# EUROPEAN PATENT SPECIFICATION

(11) **EP 2 911 465 B1**
(45) Date of publication and mention of the grant of the patent: **28.09.2016**
(21) Application number: 15151428.8
(22) Date of filing: 16.01.2015
(51) Int. Cl.: H04W 74/08, H04L 1/18

(54) **Channel access with carrier sensing mechanisms**
Kanalzugriff mit Trägererfassungsmechanismen
Accès à un canal avec des mécanismes de détection de porteuse

(30) Priority: 05.02.2014 US 201414173347
(43) Date of publication of application: 26.08.2015
(73) Proprietor: Nokia Technologies Oy, 02610 Espoo (FI)
(72) Inventor: Ghosh, Chittabrata, Fremont, CA 94538 (US)
(74) Representative: Kolster Oy Ab

(56) References cited:
- WO-A1-2014/130702
- US-A1- 2010 135 268
- US-A1- 2012 327 870
- Alfred Asterjadhi ET AL: "January 2014 0 Author(s): Name Affiliation Address Phone email", , 1 January 2014 (2014-01-01), XP055203476, Retrieved from the Internet: URL:https://mentor.ieee.org/802.11/dcn/14/ 11-14-0075-00-00ah-lb200-mac-resolution-cl ause-9-20-2-4.docx [retrieved on 2015-07-20]

## Description

### BACKGROUND

### Technical Field

The exemplary and non-limiting embodiments relate generally to wireless communication and, more particularly, to facilitating channel access.

### Brief Description of Prior Developments

The following abbreviations that may be found in the specification and/or the drawing figures are defined as follows:
- AP: - Access point
- eNB: - evolved NodeB, such as in an evolved universal mobile telecommunication system (E-UMTS)
- FCS: - frame check sequence
- IEEE: - The Institute of Electrical and Electronics Engineers
- MAC: - Media Access Control
- MCS: - Modulation and Coding Scheme
- NAV: - Network Allocation Vector
- NCE: - Network Controller Element
- PHY: - physical layer
- PPDU: - Protocall Data Unit
- PSDU: - Physical Layer Convergence Procedure (PLCP) Service Data Unit
- RID: - Response Indication Deferral
- RRC: - Radio Resource Control
- STA: - Station
- TIM: - Traffic Indication Map
- TxOP: - Transmit Opportunity
- UE: - User Equipment
- WLAN: - Wireless Local Area Network

In IEEE 802.11 specs, the purpose of the CF-END frame is to release TxOP to allow other stations to contend for channel access. US 2012/327870, US 2010/135268 and Alfred Asterjadhi et al:"January 2014 0 Author(s): Name Affiliation Address Phone email", 1 January 2014, XP055203476 are related to WLAN systems. WO 2014/130702 has priority date earlier but published later than the priority of the present document.

### SUMMARY

The following summary is merely intended to be exemplary. The summary is not intended to limit the scope of the claims.

In accordance with one aspect, a method according to claim 1 is provided.

In accordance with another aspect, a station of claims 5 is provided.

In accordance with another aspect, a method according to claim 9 is provided.

In accordance with another aspect, an access node of claim 13 is provided.

In accordance with another aspect, an example embodiment is provided in an apparatus comprising at least one processor; and at least one non-transitory memory including computer program code, the at least one memory and the computer program code configured to, with the at least one processor, cause the apparatus at least to receive by an apparatus a frame control field or a field within a Media Access Control (MAC) header in a transmission from a device, where a subfield of the field comprises a value; and determine by the apparatus, based at least partially upon the value, when the apparatus may omit transmission to the device of an indication of completion of data transmission by the apparatus to the device.

In accordance with another aspect, an example embodiment is provided in a non-transitory program storage device readable by a machine, tangibly embodying a program of instructions executable by the machine for performing operations, the operations comprising receiving by an apparatus a frame control field or a field within a Media Access Control (MAC) header in a transmission from a device, where a subfield of the field comprises a value; and determining by the apparatus, based at least partially upon the value, when the apparatus should omit transmission to the device of an indication of completion of data transmission by the apparatus to the device.

In accordance with another aspect, an example method comprises receiving by an apparatus a frame control field in a transmission from a device or a field within a Media Access Control (MAC) header, where a subfield of the field comprises a value; based at least partially upon the value, determining by the apparatus if a first counter for a first virtual carrier sensing mechanism is to be reset; and attempting to access a wireless channel by the apparatus, regardless of a value of a second counter for a second virtual carrier sensing mechanism, when the first counter for the first virtual carrier sensing mechanism is reset based upon the value.

In accordance with another aspect, an example embodiment is provided in an apparatus comprising at least one processor; and at least one non-transitory memory including computer program code, the at least one memory and the computer program code configured to, with the at least one processor, cause the apparatus at least to determine a value in a subfield of the frame control field received by the apparatus from a device or for a field within a Media Access Control (MAC) header from the device; based at least partially upon the value, determine by the apparatus if a first counter for a first virtual carrier sensing mechanism is to be reset; and attempt to access a wireless channel by the apparatus, regardless of a value of a second counter for a second virtual carrier sensing mechanism, when the first counter for the first virtual carrier sensing mechanism is reset based upon the value.

In accordance with another aspect, an example embodiment is provided in a non-transitory program storage device readable by a machine, tangibly embodying a program of instructions executable by the machine for performing operations, the operations comprising determining a value in a subfield of the frame control field or a field within a Media Access Control (MAC) header received by the apparatus from a device; based at least partially upon the value, determining by the apparatus if a first counter for a first virtual carrier sensing mechanism is to be reset; and attempting to access a wireless channel by the apparatus, regardless of a value of a second counter for a second virtual carrier sensing mechanism, when the first counter for the first virtual carrier sensing mechanism is reset based upon the value.

### BRIEF DESCRIPTION OF THE DRAWINGS

The foregoing aspects and other features are explained in the following description, taken in connection with the accompanying drawings, wherein:
Fig. 1 is a diagram illustrating an example network;
Fig. 2 is a diagram illustrating some of the components of the devices shown in Fig. 1;
Fig. 3 is a diagram illustrating signal to and from the devices shown in Fig. 1;
Fig. 4 is a diagram illustrating an example reservation release frame;
Fig. 5 is a diagram illustrating an example method;
Fig. 6 is a diagram illustrating an example method; and
Fig. 7 is a diagram illustrating an example method.

### DETAILED DESCRIPTION OF EMBODIMENTS

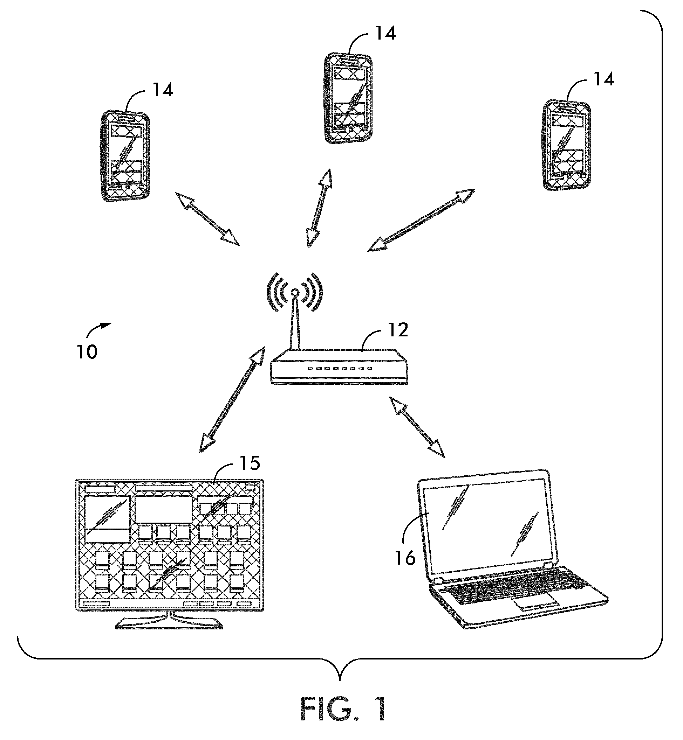

Referring to Fig. 1, a wireless communication system 10 is shown which incorporates features of example embodiments. Although the features will be described with reference to the example embodiments shown in the drawings, it should be understood that features can be embodied in many alternate forms of embodiments. The system 10 in this example is a wireless local area network (WLAN). However, features as described herein may be used with any suitable type of wireless communication system.

In the example shown the system 10 includes an access node 12 and a plurality of devices 14, 15, 16 which may communicate wirelessly with the access node 12. The access node 12 may be an access point (AP), such as a wireless router for example, connected to the Internet (not shown) for example. The devices may comprise, for example, one or more smartphones 14, one or more network capable televisions 15, and/or one or more computers 16. These are merely examples of the devices. Any other suitable device may be connect to the wireless network including, for example, smart appliances, printers, home security devices, gaming systems, tablet computers, etc.

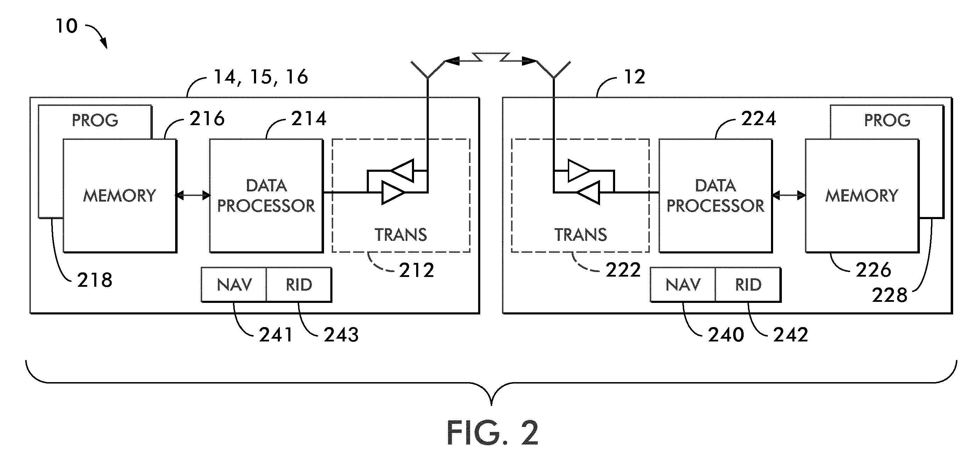

Referring also to Fig. 2, the wireless network 10 is adapted for communication over wireless links 232 between the access node 12 and the various devices 14, 15, 16. Features as described herein are not restricted to WLAN infrastructure basic service set (BSS). Features may be provided, for example, in an ad hoc network wherein the wireless links may be between two (non-AP) stations. Thus, according to an example embodiment, the access node 12 may be replaced by a station which is not an access node or an access point (AP). It may be, for example, a non-AP station for a wireless local area network.

Each of the devices 14, 15, 16 may be a station (STA) in the network 10. Each device 14, 15, 16 may include a controller, such as a computer or a data processor (DP) 214, and a computer-readable memory medium embodied as a memory (MEM) 216 that stores a program of computer instructions (PROG) 218. Each device 14, 15, 16 may also include a suitable wireless interface, such as radio frequency (RF) transceiver 212, for bidirectional wireless communications with the access node 12 via one or more antennas. Although features are being described herein with reference to the whole devices 12, 14, 15, 16, it should be noted that features as described herein may be provided in a subcomponent or assembly which is assembled into the devices 12, 14, 15, 16. For example, features by be provided in a chipset which is assembled into one or more of the devices 12, 14, 15, 16. The devices 12, 14, 15, 16 may, in some embodiments, also be referred to as a user equipment (UE).

The access node 12 also includes a controller, such as a computer or a data processor (DP) 224, a computer-readable memory medium embodied as a memory (MEM) 226 that stores a program of computer instructions (PROG) 228, and a suitable wireless interface, such as RF transceiver 222, for communication with the device 14, 15, 16 via one or more antennas. The access node 12 may be coupled via a data/control path to a NCE. The path may be implemented as an interface. The access node 12 may also be coupled to another access node via a data/control path, which may be implemented as an interface. The access node, in some embodiments, may be an eNB (evolved NodeB).

At least one of the PROGs 218, 228 is assumed to include program instructions that, when executed by the associated DP, enable the device to operate in accordance with exemplary embodiments of this invention, as will be discussed below in greater detail. That is, various exemplary embodiments of this invention may be implemented at least in part by computer software executable by the DP 214 of the device; and/or by the DP 224 of the access node, or by hardware, or by a combination of software and hardware (and firmware).

In general, the various embodiments of the device can include, but are not limited to, cellular telephones, personal digital assistants (PDAs) having wireless communication capabilities, portable computers having wireless communication capabilities, image capture devices such as digital cameras having wireless communication capabilities, gaming devices having wireless communication capabilities, music storage and playback appliances having wireless communication capabilities, Internet appliances permitting wireless Internet access and browsing, as well as portable units or terminals that incorporate combinations of such functions.

The computer readable MEMs 216, 226 may be of any type suitable to the local technical environment and may be implemented using any suitable data storage technology, such as semiconductor based memory devices, flash memory, magnetic memory devices and systems, optical memory devices and systems, fixed memory and removable memory. The DPs 214, 224 may be of any type suitable to the local technical environment, and may include one or more of general purpose computers, special purpose computers, microprocessors, digital signal processors (DSPs) and processors based on a multicore processor architecture, as non-limiting examples. The wireless interfaces (e.g., RF transceivers 212 and 222) may be of any type suitable to the local technical environment and may be implemented using any suitable communication technology such as individual transmitters, receivers, transceivers or a combination of such components.

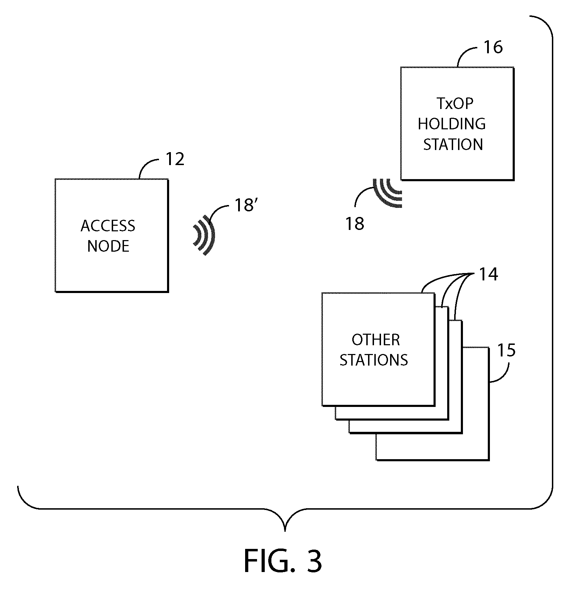

Referring also to Fig. 3, in this example the computer 16 is in communication with the access node 12. According to an example embodiment, there may be two categories of stations (STAs); one the traffic indication map (TIM) STAs and the other non-TIM STAs. TIM STAs may be required to decode long and/or short beacons for indication of presence of their buffered downlink data at the AP. This may be an IEEE 802.11 network for example. The carrier sensing mechanisms of the network 10 are defined in order to restrict transmissions while a STA (12, 14, 15 or 16) is currently transmitting. In general, a STA's state may be in any one mode at a particular time, either in receive (Rx) mode or in transmit (Tx) mode, and not in both mode at the same time. In an example embodiment, the network 10 may use more than one virtual carrier sensing mechanism, namely NAV (Network Allocation Vector) and RID (Response Indication Deferral). However, in an alternate example more than two virtual carrier sensing mechanisms could be used. In one more embodiment, only one virtual carrier sensing mechanism could be used. The devices 12, 14, 15, 16 may have NAV counters 240, 241 and RID counters 242, 243 schematically illustrated in Fig. 2. Organizations are currently trying to agree on a specification for IEEE 802.11ah, but no final agreement has been reached yet. In some proposals for IEEE 802.11ah there are two counters, a NAV counter and a RID counter, both of which need to be zero to conclude that the medium is idle. Response Indication Deferral (RID) has been proposed for the IEEE 802.11ah standard as a second virtual sensing mechanism to the conventional NAV virtual carrier sensing mechanism. Features as described herein may be used with one or more any suitable type of virtual sensing mechanism; not necessarily only NAV and/or RID. Use of NAV and RID in this description is merely an example.

Similar to the concept of the NAV counter, the RID counter is set or reset prior to access of a medium. The RID counter is modified based on the RXVECTOR value of the LENGTH parameter in SIG field of PHY header. The NAV counter, on the other hand, is modified based on the DURATION field in the MAC header. In addition, the RXVECTOR value is invoked by the PHY layer by using two primitives namely, PHY-RXSTART.indication and PHY-RXEND.indication.

The RID counter allows a STA (not the intended receiver or the transmitter - 12, 16 in the example shown in Fig. 3) to defer medium access for the duration (PPDU time + the expected time of the response frame) specified by RXVECTOR value without the need to decode the DURATION field (i.e., decoding all the MSDU) in the MAC header. Hence, the STA, upon reception of the SIG field of the frame, already knows the amount of time it should defer. It can use that time for power saving, such as going to sleep for example. Hence, the introduction of the RID counter may be beneficial from the perspective of low power sensors in an IEEE 802.11 network.

A proposed solution of resetting the NAV with respect to the PHY-RXEND.indication primitive is:
"When an SIG STA receives a CF-END frame with the Duration/ID field set to a non-zero duration value that is equal to the NAV value +/- 8 µsec at the time of the reception of the PHY-RXEND.indication, it shall reset the NAV and may start contending for the medium without further delay. If the received duration value is not equal to the NAV value +/- 8 µsec at the time of the reception of the PHY-RXEND.indication, the STA shall discard the CF-END frame."

This proposed solution assumes correct reception of the PHY-RXEND.indication primitive in order to reset the NAV. However, there can be three (3) cases where the PHY-RXEND.indication primitive can be received in error at the MAC sublayer from the PHY layer. The following are the three instances of error:
PHY-RXEND.indication(FormatViolation) primitive
PHY-RXEND.indication(CarrierLost) primitive
PHY-RXEND.indication(UnsupportedRate) primitive

It is natural to assume (since the SIG field is always transmitted in lowest modulation and coding scheme (MCS)) that the PHY-RXSTART.indication (RXVECTOR) primitive completes with the PHY header of the CF-END frame being received correctly at the MAC sublayer from the PHY layer. Based on the RXVECTOR vector of the LENGTH parameter in the received SIG field of a frame, the RID counter is set to the corresponding value. If the PHY-RXEND.indication primitive indicates an erroneous reception of PSDU due to the above three reasons, it implies to the MAC sublayer that the PHY header of the received CF-END frame is decoded properly, but not the MAC header (transmitted at higher MCS) of the CF-END frame. In such a case, the NAV counter is not reset, although the RID counter is modified. The above noted NAV resetting, thus, fails to take into account such a scenario. Due to failure of reception of the MAC header of CF-END frame, the following circumstances may arise:
(i) The RID counter is reset, but the NAV counter is not reset (due to an erroneous MAC header reception): In this case, the STA is unable to contend for medium access even though the medium is idle after CF-END frame transmission by the TxOP holder STA. The NAV counter is still unchanged at the maximum value of the TxOP. This leads to an unfairness issue of channel access (since the STAs receiving the CF-END frame correctly can contend) and unnecessary power consumption in continuing to be awake until the end of the TxOP.
(ii) The RID counter is reset on the first CF-END frame, but the AP still sends the second CF-END frame: There is a probability that the MAC header is received correctly since transmitted by the AP; although the RID counter was reset at the first CF-END frame transmission, the NAV is now reset (from the maximum TxOP value) to zero on receiving the PHY-RXEND.indication primitive, i.e., the receive state machine has completed reception of second CF-END frame. There is unnecessary energy consumption since the NAV was not reset until the second CF-END frame, although the RID counter was reset.

Transmission of both the first CF-END (from the STA to the AP) and the second CF-END (repetition of the first CF-END transmitted by AP to other STAs to let hidden nodes to receive the CF-END as well) may cause the receivers of first CF-END frame to try to access the channel when the AP transmits the second CF-END Frame. Due to possible collision, the hidden nodes may not receive the second CF-END frame.

Features as described herein discuss mechanisms for power saving. This may be done, for example, by introducing values of a RESPONSE_INDICATION in the RXVECTOR vector of the LENGTH parameter in the SIG field of the PHY header. For example, a RESPONSE_INDICATION parameter within the CF-END frame may be modified differently based on whether it is a unicast CF-END frame or a broadcast CF-END frame. Please note that these are merely examples, and should not be considered as limiting. Features may be provided in any suitable subfield, field or frame.

An example method for STAs, as well as the AP, is to indicate whether a second CF-END frame needs to be transmitted or not. According to example embodiments, the access node may decide on transmission independently, such as when the first CD-End frame does not request it. A method may be used to modify the Frame Control field to indicate RESPONSE_INDICATION within the unicast CF-END frame sent by a STA.

Based on the value indicated in the RESPONSE_INDICATION subfield, the STAs may set a RESPONSE_INDICATION value of either No Response or Normal Response. No Response may be set in order to signal to reset the RID counter. Normal Response may be set to signal to wait for the receipt of the broadcast CF-END frame transmission from the AP. This value enables the non-TxOP STAs (not the TxOP holder station) to reset the RID and access the channel.

In one example embodiment a method may be provided for resetting a virtual carrier sensing, here the RID counter, in order to facilitate channel access by a STA not holding the TxOP when the medium is freed up by the TxOP holding STA. The RID value may be set to a value based on the value of the RXVECTOR parameter RESPONSE_INDICATION of the received frame.

### PROPOSED SIGNALING:

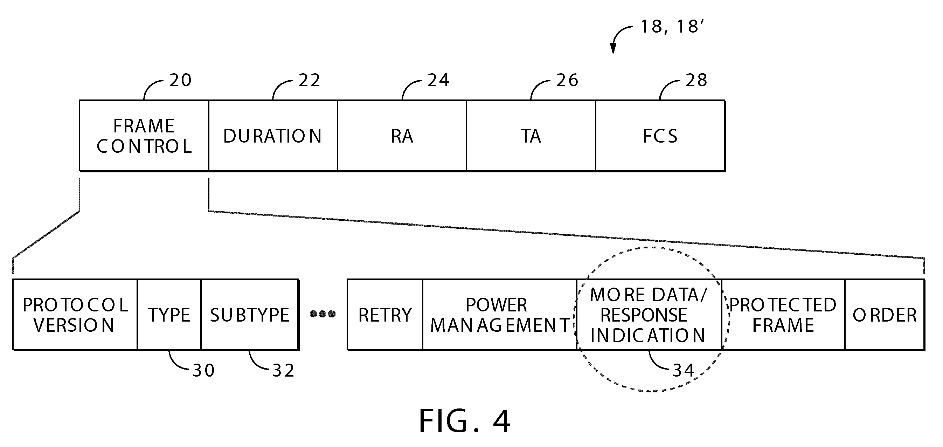

Referring also to Fig. 4, a CF-END frame 18 comprising, features as described herein, may consist of a Frame Control field 20 and other fields namely Duration 22, RA 24, TA 26, and FCS 28. Use of one of the subfields in the Frame Control field 20 for the CF-END frame 18 has been modified to enable features as described herein. The Type 30 and Subtype 32 fields within the Frame Control field 20 indicate a CF-END frame. Based upon this indication, the existing More Data 34 subfield may now be interpreted as the RESPONSE_INDICATION subfield. The More Data field is normally used to indicate to a station in PS mode that more MSDUs or MMPDUs are buffered for that station at the AP. However, with features as described herein, the field may be used for the RESPONSE_INDICATION value indication purpose. In an alternate example, the signaling bit may occur anywhere in the MAC header. Thus, the specific subfield noted above does not need to be replaced with the RESPONSE_INDICATION subfield. That is merely an example.

### Example Behavior: RESPONSE_INDICATION value by TxOP Holder

With reference to Fig. 3, the TxOP holder STA 16, once it has completed all data transmissions, sends a CF-END frame 18. The TxOP holder STA 16 may set the value in the RESPONSE_INDICATION subfield 34 to "1" if it intends to receive another CF-END frame from the AP 12. On the other hand, the TxOP holder station 16 may set the value in the RESPONSE_INDICATION subfield 34 to "0" (zero) if it does not intend to receive another CF-END frame from the AP 12. Correspondingly, if the value in the RESPONSE_INDICATION subfield 34 is set to "1", the STA shall set the RESPONSE_INDICATION parameter to Normal Response in the RXVECTOR value. Similarly, if the value in the RESPONSE_INDICATION subfield is set to "0", the STA shall set the RESPONSE_INDICATION parameter to No Response.

### Example Behavior: RESPONSE_INDICATION value by TxOP Responder AP:

If the AP 12 receives the CF END frame 18 from the TxOP holder STA 16, the AP 12 checks for the value in the RESPONSE_INDICATION subfield 34 of the Frame Control field 20. If the value in the RESPONSE_INDICATION subfield is set to "1", the AP 12 may send a CF-END frame 18' in response. On the other hand, if the value in the RESPONSE_INDICATION subfield 34 is set to "0", the AP 12 may optionally not send the second CF-END frame 18' in response. However, even if the value in the RESPONSE_INDICATION subfield 34 is set to "0", the AP 12 may still send the second CF-END frame 18' if the AP 12 decides to based on the knowledge of the environment. The AP 12 may set the value in the RESPONSE_INDICATION subfield in the Frame Control field of CF-END frame to "0". Correspondingly, since the value in the Response Indication subfield is set to "0", the AP may set the RESPONSE_INDICATION parameter to No Response.

### Receiving STAs (14, 15):

### Example Behavior: Response Indication bit set to "0":

STAs 14, 15 that receive the PHY-RXSTART.indication primitive may reset the RID counter based on the NO Response value in RESPONSE_INDICATION parameter (either in the first CF-END frame send by the STA 16 or second CF-END frame send by the AP 12, respectively). Prior to channel access, each STA 14, 15 compares the value of the RID and the NAV after receipt of the CF END frame. If any of these counters (the RID counter or the NAV counter) reach a value of "0", the STA 14, 15 may attempt to access the channel immediately.

When STAs 14, 15 receive an erroneous RXEND.indication primitive, they will not be able to reset their NAV counter. However, if the RID counter reaches a value of 0, a STA may attempt to access the channel immediately without waiting for the second CF-END frame and regardless of the value of the NAV counter. This proposed rule solves both the circumstances posed above.

### Example Behavior: Response Indication bit set to "1":

STAs 14, 15 may set their RID counter to NormalTxTime + aSIFSTime based on the Normal Response value in RESPONSE_INDICATION parameter of the CF-END frame sent by the STA 16. If the MAC header of CF END frame is received in error, the NAV counter is still set to the maximum TxOP limit. On receiving the second CF-END frame from the AP 12 with NO Response in RESPONSE_INDICATION, the RID counter may be reset. Additionally, with the correct reception of the second CF-END frame MAC header, the NAV counter may also reset. The STAs 14, 15 may contend for the channel immediately.

The immediate advantage of this rule is to allow power constrained IEEE 802.11 STAs to access a medium when one holding STA in the TxOP has completed transmissions prior to the end of the TxOP duration. The proposed mechanism will resolve the deadlock situation noted above.

With features as described herein, the TxOP holder, which wants to release the TxOP by sending a CF-END frame, may decide whether it is mandatory or optional for the access point 12 to transmit the second CF-END Frame. When other stations 14, 15 receive the first CF-END Frame 18, they can see from its parameters whether transmission of the second CF-END frame 18' from the AP 12 is mandatory or not. If it is mandatory, the other stations 14, 15 defer channel access until receiving the second CF-END frame 18'. If parameters show that second CF-END frame 18' might not follow, the stations 14, 15 may start contending for channel access immediately. One of the differentiating features is that the TxOP holder may coordinate whether the AP must respond to the CF-END frame 18 from the TxOP holder or whether it is optional.

In current proposals for IEEE 802.11ah a Response Indication is not provided to tell what kind of response is expected. In current proposals for IEEE 802.11ah there is no proposed use of Response Indication for a CF-END Frame. In current proposals for IEEE 802.11ah there is no proposal of a second CF-END frame not being a required real response to the first CF-END frame. In current proposals for IEEE 802.11ah the issue wherein the receiver, such as AP 12 for example, may decide itself whether it transmits a second CF-END frame is not addressed, i.e. the request indication would indicate whether the repetition is mandatory or optional.

With features as described herein, a STA may send a CF-END frame to an access node to indicate (e.g. in one bit set to "1") that the access node is required to send another CF-END frame, and when the access node is not required to send the another CF-END frame (e.g. in one bit set to "0"), and the access node may still optionally send the other CF-END frame based on its knowledge of the environment, which is typically much more accurate than the knowledge of the environment of the STA that is sending the first CF-END frame.

If a STA receives the first/second CF-END frame to communication, to which the STA is not participating (i.e. after releasing its own TxOP), then the STA may again access the channel if other STAs had started the TxOP and now release it.

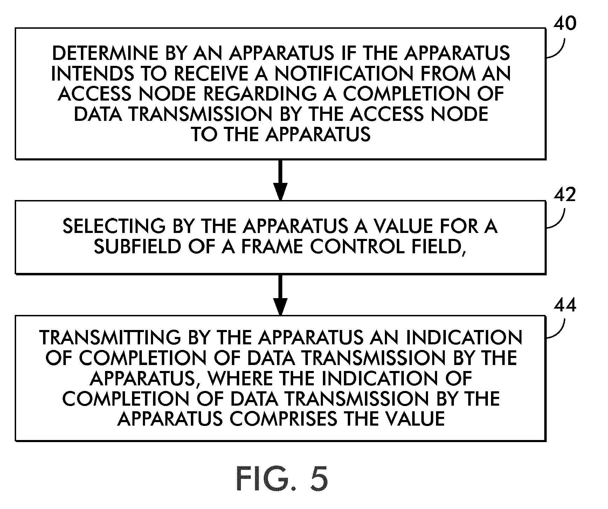

Referring also to Fig. 5, an example method may comprise determining by an apparatus as indicated by block 40 if the apparatus intends to receive a notification from an access node regarding a completion of data transmission by the access node to the apparatus; based upon the determining, selecting by the apparatus a value for a subfield of a frame control field as indicated by block 42 or for a field within a Media Access Control (MAC) header; and transmitting by the apparatus an indication of completion of data transmission by the apparatus as indicated by block 44, where the indication of completion of data transmission by the apparatus comprises the value. The apparatus may be a transmit opportunity (TxOP) holding station and the access node may be an access point (AP). The value may be in a RESPONSE_INDICATION subfield in a frame control field of a reservation release frame.

The notification may be a reservation release frame for example. The notification may be CF-End frame for example. The CF-End frame may be based on CF-End frames; defined in IEEE 802.11 task groups for example. The notification may be a second reservation release frame or a second CF-End frame, following a first reservation release frame or a first CF-End frame for example. The indication of completion of data transmission may be a reservation release frame or a CF-End frame for example. The indication of completion of data transmission may be a first reservation release frame or a first CF-End frame for example.

An example embodiment may be provided in an apparatus comprising at least one processor; and at least one non-transitory memory including computer program code, the at least one memory and the computer program code configured to, with the at least one processor, cause the apparatus at least to determine if the apparatus intends to receive a notification from an access node regarding completion of data transmission by the access node to the apparatus; and based upon the determination, select by the apparatus a value for a subfield of a frame control field or for a field within a Media Access Control (MAC) header. The apparatus may be a transmit opportunity (TxOP) holding station and the access node may be an access point (AP). The value may be in a RESPONSE_INDICATION subfield in a frame control field of a reservation release frame. The reservation release frame may be a CF-End frame for example.

An example embodiment may be provided in a non-transitory program storage device such as 216 for example readable by a machine, tangibly embodying a program of instructions executable by the machine for performing operations, the operations comprising determining if an apparatus intends to receive a notification, from an access node, regarding completion of data transmission by the access node to the apparatus; and based upon the determining, selecting by the apparatus a value for a subfield of a frame control field or for a field within a Media Access Control (MAC) header.

Any combination of one or more computer readable medium(s) may be utilized as the memory. The computer readable medium may be a computer readable signal medium or a non-transitory computer readable storage medium. A non-transitory computer readable storage medium does not include propagating signals and may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing.

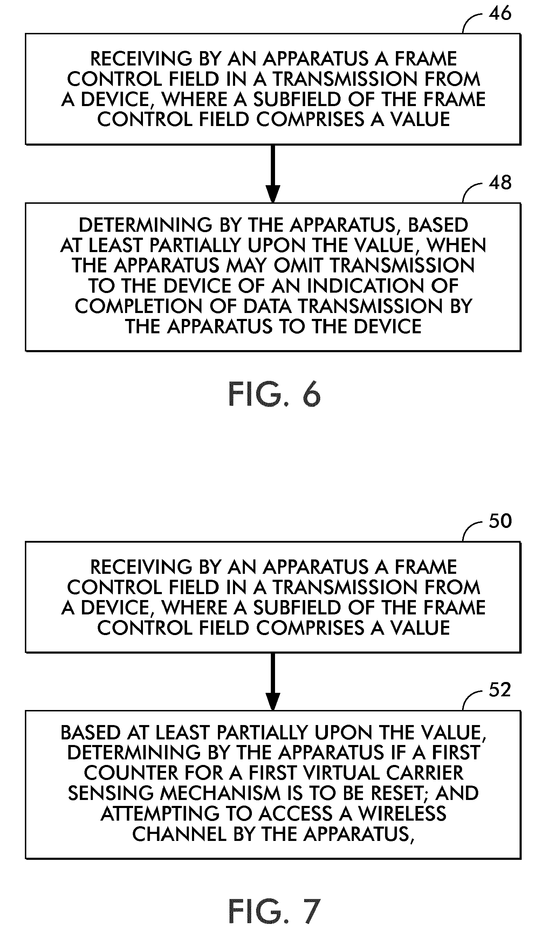

Referring also to Fig. 6, an example method may comprise receiving by an apparatus a frame control field in a transmission from a device as indicated by block 46, where a subfield of the frame control field comprises a value; and determining by the apparatus, based at least partially upon the value, when the apparatus may omit transmission to the device of an indication of completion of data transmission by the apparatus to the device as indicated by block 48. The device may be a transmit opportunity (TxOP) holding station and the apparatus may be an access point (AP). The subfield may be in a RESPONSE_INDICATION subfield of the frame control field, and the frame control field may be in a reservation release frame of the transmission from the device. The method may further comprise, based at least partially upon the determining of when the apparatus may omit transmission to the device of the indication, determining if the apparatus should transmit the indication from the apparatus to the device or not transmit the indication from the apparatus to the device.

An example embodiment may be provided in an apparatus comprising at least one processor; and at least one non-transitory memory including computer program code, the at least one memory and the computer program code configured to, with the at least one processor, cause the apparatus at least to receive by an apparatus a frame control field in a transmission from a device, where a subfield of the frame control field comprises a value; and determine by the apparatus, based at least partially upon the value, when the apparatus may omit transmission to the device of an indication of completion of data transmission by the apparatus to the device. The device may be a transmit opportunity (TxOP) holding station and the apparatus may be an access point (AP). The subfield may be in a RESPONSE_INDICATION subfield of the frame control field, and where the frame control field is in a reservation release frame of the transmission from the device. The at least one memory and the computer program code may be configured to, with the at least one processor, cause the apparatus to, based at least partially upon the determining of when the apparatus may omit transmission to the device of the indication, determine if the apparatus should transmit the indication from the apparatus to the device or not transmit the indication from the apparatus to the device.

An example embodiment may be provided in an apparatus comprising a non-transitory program storage device such as 226 for example readable by a machine, tangibly embodying a program of instructions executable by the machine for performing operations, the operations comprising receiving by an apparatus a frame control field in a transmission from a device, where a subfield of the frame control field comprises a value; and determining by the apparatus, based at least partially upon the value, when the apparatus should omit transmission to the device of an indication of completion of data transmission by the apparatus to the device. The device may be a transmit opportunity (TxOP) holding station and where the apparatus is an access point (AP), and where the subfield may be in a RESPONSE_INDICATION subfield of the frame control field, and where the frame control field is in a reservation release frame of the transmission from the device.

Referring also to Fig. 7, an example method may comprise receiving by an apparatus a frame control field in a transmission from a device as indicated by block 50, where a subfield of the frame control field comprises a value; based at least partially upon the value, determining by the apparatus if a first counter for a first virtual carrier sensing mechanism is to be reset; and attempting to access a wireless channel by the apparatus as indicated by block 52, regardless of a value of a second counter for a second virtual carrier sensing mechanism, when the first counter for the first virtual carrier sensing mechanism is reset based upon the value.

An example embodiment may be provided in an apparatus comprising at least one processor; and at least one non-transitory memory including computer program code, the at least one memory and the computer program code configured to, with the at least one processor, cause the apparatus at least to determine a value in a subfield of the frame control field received by the apparatus from a device; based at least partially upon the value, determine by the apparatus if a first counter for a first virtual carrier sensing mechanism is to be reset; and attempt to access a wireless channel by the apparatus, regardless of a value of a second counter for a second virtual carrier sensing mechanism, when the first counter for the first virtual carrier sensing mechanism is reset based upon the value.

An example embodiment may be provided in an apparatus comprising a non-transitory program storage device readable by a machine, tangibly embodying a program of instructions executable by the machine for performing operations, the operations comprising determining a value in a subfield of the frame control field received by the apparatus from a device; based at least partially upon the value, determining by the apparatus if a first counter for a first virtual carrier sensing mechanism is to be reset; and attempting to access a wireless channel by the apparatus, regardless of a value of a second counter for a second virtual carrier sensing mechanism, when the first counter for the first virtual carrier sensing mechanism is reset based upon the value.

Features may be provide in a method or apparatus by means for determining by an apparatus if the apparatus intends to receive a notification from an access node regarding a completion of data transmission by the access node to the apparatus; based upon the determining, means for selecting by the apparatus a value for a subfield of a frame control field; and means for transmitting by the apparatus an indication of completion of data transmission by the apparatus, where the indication of completion of data transmission by the apparatus comprises the value.

Features may be provide in a method or apparatus by means for receiving by an apparatus a frame control field in a transmission from a device, where a subfield of the frame control field comprises a value; and means for determining by the apparatus, based at least partially upon the value, when the apparatus may omit transmission to the device of an indication of completion of data transmission by the apparatus to the device.

Features may be provide in a method or apparatus by means for receiving by an apparatus a frame control field in a transmission from a device, where a subfield of the frame control field comprises a value; based at least partially upon the value, means for determining by the apparatus if a first counter for a first virtual carrier sensing mechanism is to be reset; and means for attempting to access a wireless channel by the apparatus, regardless of a value of a second counter for a second virtual carrier sensing mechanism, when the first counter for the first virtual carrier sensing mechanism is reset based upon the value.

Features as described herein may be used for controlling behavior of channel access based on virtual carrier sensing (such as a RID counter for exmaple) with respect to an indication. Behavior of channel access may be based on RID in CF-END frame for example; a 1 bit indication in the CF-END frame. With features as described herein, an indication may be added such that STAs (not the TXOP holder) can set the NAV accordingly, and access a channel after either the first CF-END frame reception or the second CF-END frame reception.

It should be understood that the foregoing description is only illustrative. Various alternatives and modifications can be devised by those skilled in the art. For example, features recited in the various dependent claims could be combined with each other in any suitable combination(s). In addition, features from different embodiments described above could be selectively combined into a new embodiment. Accordingly, the description is intended to embrace all such alternatives, modifications and variances which fall within the scope of the appended claims.

## Claims

1. A method comprising:
determining (40) by a transmission opportunity holding station (14, 15, 16) for an IEEE 802.11 based network whether said station intends to receive a notification on a channel from an access node (12) for an IEEE 802.11 based network regarding a completion of data transmission;
based upon the determining, selecting (42) by said station a value for a parameter; and
transmitting (44) by said station an indication of completion of data transmission on the channel to the access node, wherein the indication of completion of data transmission comprises the parameter.

2. A method of claim 1, wherein the access node is an access point (AP).

3. A method of any preceding claim 1 to 2, wherein the parameter is a RESPONSE_INDICATION parameter of a reservation release frame.

4. A method of any preceding claims 1 to 3, wherein the reservation release frame is a CF-End frame.

5. A transmission opportunity holding station (14, 15, 16) for an IEEE 802.11 based network comprising:
means (214, 215, 218) for determining whether said station intends to receive a notification from an access node for an IEEE 802.11 based network regarding a completion of data transmission;
means (214, 215, 218) for selecting, based upon the determination, a value for a parameter; and
means (212, 214, 215, 218) for transmitting an indication of completion of data transmission, wherein the indication of completion of data transmission comprises the parameter.

6. A station of claim 5, wherein the access node is an access point (AP).

7. A station of any preceding claim 5 to 6, wherein the parameter is a RESPONSE_INDICATION parameter of a reservation release frame.

8. A station of any preceding claim 5 to 7, wherein the reservation release frame is a CF-End frame.

9. A method comprising:
receiving (46) by an access node for an IEEE 802.11 based network a first indication of completion of data transmission from a transmission opportunity holding station for an IEEE 802.11 based network, wherein the first indication comprises a parameter; and
determining (48) by the access node, based at least partially upon the parameter, whether the access node may omit transmission to said station of a second indication of completion of data transmission.

10. A method of claim 8, wherein the access node is an access point (AP).

11. A method of any preceding claim 9 to 10, wherein the parameter is a RESPONSE_INDICATION parameter of a reservation release frame.

12. A method of any preceding claim 9 to 11 further comprising, based at least partially upon the determining of whether the access node may omit transmission to said station of the second indication, determining if the access node should transmit the second indication from the access node to said station or not to transmit the second indication from the access node to said station.

13. An access node for an IEEE 802.11 based network comprising:
means (222, 224, 226, 228) for receiving by an access node a transmission of a first indication from a transmission opportunity holding station for an IEEE 802.11 based network, wherein the first indication comprises a parameter; and
means (224, 226, 228) for determining by the access node, based at least partially upon the parameter, whether the access node may omit transmission to said station of a second indication of completion of data transmission.

14. An access node of claim 13, wherein the access node is an access point (AP).

15. An access node of any preceding claim 13 to 14, wherein the parameter is a RESPONSE_INDICATION parameter of a reservation release frame.

## Patentansprüche

1. Verfahren, das Folgendes umfasst:
Bestimmen (40) durch eine Sendegelegenheit-Haltestation (14, 15, 16) für ein Netz auf IEEE 802.11-Basis, ob die Station beabsichtigt, auf einem Kanal von einem Zugriffsknoten (12) für ein Netz auf IEEE 802.11-Basis eine Meldung hinsichtlich eines Abschlusses einer Datenübertragung zu empfangen;
auf der Basis des Bestimmens Auswählen (42) durch die Station eines Wertes für einen Parameter; und
Senden (44) durch die Station einer Angabe des Abschlusses der Datenübertragung auf dem Kanal zu dem Zugriffsknoten, wobei die Angabe des Abschlusses der Datenübertragung den Parameter enthält.

2. Verfahren nach Anspruch 1, wobei der Zugriffsknoten ein Zugriffspunkt (AP) ist.

3. Verfahren nach einem vorhergehenden Anspruch 1 bis 2, wobei der Parameter ein RESPONSE_INDICATION-Parameter eines Reservierungsfreigaberahmens ist.

4. Verfahren nach einem der vorhergehenden Ansprüche 1 bis 3, wobei der Reservierungsfreigaberahmen ein CF-Endrahmen ist.

5. Sendegelegenheit-Haltestation (14, 15, 16) für ein Netz auf IEEE 802.11-Basis, die Folgendes umfasst:
Mittel (214, 215, 218) zum Bestimmen, ob die Station beabsichtigt, von einem Zugriffsknoten für ein Netz auf IEEE 802.11-Basis eine Meldung hinsichtlich eines Abschlusses einer Datenübertragung zu empfangen;
Mittel (214, 215, 218), um auf der Grundlage der Bestimmung einen Wert für einen Parameter auszuwählen; und
Mittel (212, 214, 215, 218) zum Senden einer Angabe des Abschlusses der Datenübertragung, wobei die Angabe des Abschlusses einer Datenübertragung den Parameter enthält.

6. Station nach Anspruch 5, wobei der Zugriffsknoten ein Zugriffspunkt (AP) ist.

7. Station nach einem vorhergehenden Anspruch 5 bis 6, wobei der Parameter ein RESPONSE_INDICATION-Parameter eines Reservierungsfreigaberahmens ist.

8. Station nach einem vorhergehenden Anspruch 5 bis 7, wobei der Reservierungsfreigaberahmen ein CF-Endrahmen ist.

9. Verfahren, das Folgendes umfasst:
Empfangen (46) durch einen Zugriffsknoten für ein Netz auf IEEE 802.11-Basis einer ersten Angabe eines Abschlusses einer Datenübertragung von einer Sendegelegenheit-Haltestation für ein Netz auf IEEE 802.11-Basis, wobei die erste Angabe einen Parameter enthält; und
Bestimmen (48) durch den Zugriffsknoten wenigstens teilweise anhand des Parameters, ob der Zugriffsknoten die Übertragung einer zweiten Angabe des Abschlusses einer Datenübertragung zu der Station unterlassen kann.

10. Verfahren nach Anspruch 8, wobei der Zugriffsknoten ein Zugriffspunkt (AP) ist.

11. Verfahren nach einem vorhergehenden Anspruch 9 bis 10, wobei der Parameter ein RESPONSE_INDICATION-Parameter eines Reservierungsfreigaberahmens ist.

12. Verfahren nach einem vorhergehenden Anspruch 9 bis 11, das ferner wenigstens teilweise anhand der Bestimmung, ob der Zugriffsknoten die Übertragung zu der Station der zweiten Angabe weglassen kann, Folgendes umfasst: Bestimmen, ob der Zugriffsknoten die zweite Angabe von dem Zugriffsknoten zu der Station senden sollte oder nicht, um die zweite Angabe von dem Zugriffsknoten zu der Station zu senden.

13. Zugriffsknoten für ein Netz auf IEEE 802.11-Basis, der Folgendes umfasst:
Mittel (222, 224, 226, 228) zum Empfangen durch einen Zugriffsknoten einer Übertragung einer ersten Angabe von einer Sendegelegenheit-Haltestation für ein Netz auf IEEE 802.11-Basis, wobei die erste Angabe einen Parameter enthält; und
Mittel (224, 226, 228), um durch den Zugriffsknoten wenigstens teilweise anhand des Parameters zu bestimmen, ob der Zugriffsknoten eine Übertragung einer zweiten Angabe des Abschlusses einer Datenübertragung zu der Station weglassen kann.

14. Zugriffsknoten nach Anspruch 13, wobei der Zugriffsknoten ein Zugriffspunkt (AP) ist.

15. Zugriffsknoten nach einem vorhergehenden Anspruch 13 bis 14, wobei der Parameter ein RESPONSE_INDICATION-Parameter eines Reservierungsfreigaberahmens ist.

## Revendications

1. Procédé comprenant les étapes suivantes :
déterminer (40) par une station de maintien d'opportunité de transmission (14, 15, 16) pour un réseau basé sur IEEE 802.11 si ladite station entend recevoir une notification sur un canal depuis un noeud d'accès (12) pour un réseau basé sur IEEE 802.11 concernant un achèvement de transmission de données ;
sur la base de la détermination, sélectionner (42), par ladite station, une valeur pour un paramètre ; et
transmettre (44), par ladite station, une indication d'achèvement de transmission de données sur le canal vers le noeud d'accès, où l'indication d'achèvement de la transmission de données comprend le paramètre.

2. Procédé selon la revendication 1, dans lequel le noeud d'accès est un point d'accès (AP).

3. Procédé selon l'une quelconque des revendications précédentes 1 à 2, dans lequel le paramètre est un paramètre RESPONSE_INDICATION d'une trame de libération de réservation.

4. Procédé d'une des revendications précédentes 1 à 3, dans lequel la trame de libération de réservation est une trame CF-End.

5. Station de maintien d'opportunité de transmission (14, 15, 16) pour un réseau basé sur IEEE 802.11 comprenant :
des moyens (214, 215, 218) pour déterminer si ladite station entend recevoir une notification depuis un noeud d'accès pour un réseau basé sur IEEE 802.11 concernant un achèvement de transmission de données ;
des moyens (214, 215, 218) pour sélectionner, sur la base de la détermination, une valeur pour un paramètre ; et
des moyens (212, 214, 215, 218) pour transmettre une indication d'achèvement de transmission de données, où l'indication d'achèvement de transmission de données comprend le paramètre.

6. Station selon la revendication 5, dans laquelle le noeud d'accès est un point d'accès (AP).

7. Station selon l'une quelconque des revendications précédentes 5 à 6, dans laquelle le paramètre est un paramètre RESPONSE_INDICATION d'une trame de libération de réservation.

8. Station selon l'une quelconque des revendications précédentes 5 à 7, dans laquelle la trame de libération de réservation est une trame CF-End.

9. Procédé comprenant les étapes suivantes :
recevoir (46), par un noeud d'accès pour un réseau basé sur IEEE 802.11, une première indication d'achèvement de transmission de données depuis une station de maintien d'opportunité de transmission pour un réseau basé sur IEEE 802.11, où la première indication comprend un paramètre ; et
déterminer (48), par le noeud d'accès, sur la base au moins partiellement du paramètre, si le noeud d'accès peut omettre une transmission vers ladite station d'une seconde indication d'achèvement de transmission de données.

10. Procédé selon la revendication 8, dans lequel le noeud d'accès est un point d'accès (AP).

11. Procédé selon l'une quelconque des revendications précédentes 9 à 10, dans lequel le paramètre est un paramètre RESPONSE_INDICATION d'une trame de libération de réservation.

12. Procédé selon l'une quelconque des revendications précédentes 9 à 11, comprenant en outre, sur la base au moins partiellement de la détermination du fait que le noeud d'accès puisse, ou non, omettre une transmission vers ladite station de la seconde indication, de déterminer si le noeud d'accès doit transmettre la seconde indication depuis le noeud d'accès vers ladite station ou ne pas transmettre la seconde indication depuis le noeud d'accès vers ladite station.

13. Noeud d'accès pour un réseau basé sur IEEE 802.11, comprenant :
des moyens (222, 224, 226, 228) pour recevoir, par un noeud d'accès, une transmission d'une première indication depuis une station de maintien d'opportunité de transmission pour un réseau basé sur IEEE 802.11, où la première indication comprend un paramètre ; et
des moyens (224, 226, 228) pour déterminer, par le noeud d'accès, sur la base au moins partiellement du paramètre, si le noeud d'accès peut omettre une transmission vers ladite station d'une seconde indication d'achèvement de transmission de données.

14. Noeud d'accès selon la revendication 13, dans lequel le noeud d'accès est un point d'accès (AP).

15. Noeud d'accès selon l'une quelconque des revendications précédentes 13 à 14, dans lequel le paramètre est un paramètre RESPONSE_INDICATION d'une trame de libération de réservation.
